# EUROPEAN PATENT APPLICATION

(11) **EP 4 815 666 A1**
(43) Date of publication of application: **30.09.2026**
(21) Application number: 25224768.9
(22) Date of filing: 18.12.2025
(51) Int. Cl.: H10D 30/01, H10D 30/00, H10D 62/13, H10D 62/83, H10D 62/834, H10D 64/01, H10D 64/23

(54) **TRANSISTOR STRUCTURES WITH SCAVENGING MATERIAL WITHIN SOURCE/DRAIN CONTACT METALLIZATION**

(30) Priority: 28.03.2025 US 202519094255
(71) Applicant: Intel Corporation, Santa Clara, CA 95054 (US)
(72) Inventor: SEN GUPTA, Arnab, Hillsboro, OR 97123 (US); KARPOV, Ilya, Portland, OR 97229 (US); HARATIPOUR, Nazila, Portland, OR 97239 (US); METZ, Matthew, Portland, OR 97229 (US); DEWEY, Gilbert, Beaverton, OR 97006 (US); LI, Wenshen, Fremont, CA 94555 (US); ZELICK, Nancy, Baker City, OR 97814 (US); TUNG, I-Cheng, Hillsboro, OR 97124 (US); JEZEWSKI, Christopher, Portland, OR 97229 (US); MICHAELOS, Thoe, Portland, OR 97212 (US); CHOUKSEY, Siddharth, Portland, OR 97229 (US)
(74) Representative: HGF

(57) **Abstract**

Transistor structures with source/drain contact metallization that includes an oxygen scavenging material. By incorporating the oxygen scavenging material, oxidation of a contact liner metallization that interfaces with semiconductor source/drain material may be reduced and a source/drain contact metallization structure may display improved stability.

## Description

### BACKGROUND

In advanced integrated circuits (ICs), field effect transistor (FET) architectures are becoming increasingly complex. Fabricating contact metallization to source and drain terminals of sufficiently low resistance is becoming more difficult as device architectural complexity increases. Some materials that might otherwise be promising candidates for reducing contact resistance display instability, for example with source/drain contact resistance increasing over time and/or with further processing. Accordingly, frontend IC architectures and fabrication techniques that can improve contact metallization material stability are therefore commercially advantageous.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of fabricating transistor structures with source/drain contact metallization that includes an oxygen scavenging material, in accordance with some embodiments;
FIG. 2, 3, 4, 5 and 6 are cross-sectional views of transistor structures evolving as the methods illustrated in FIG. 1 are practiced, in accordance with some embodiments;
FIG. 7 illustrates a mobile computing platform and a data server machine employing an IC device including transistor structures with source/drain contact metallization that includes a scavenging material, in accordance with some embodiments; and
FIG. 8 is a functional block diagram of an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. In one example, two compositions that are substantially the same, have only incidental chemical variation. As another example, composition that is substantially a first constituent means the composition may further include <1% of any other constituent. A composition that is substantially first and second constituents means the composition may further include <1% of any constituent substituted for either the first or second constituent.

In accordance with embodiments herein, transistor source/drain contact metallization includes an oxygen scavenging material, which may retard oxidation of an underlying contact liner metallization that interfaces with semiconductor source/drain material. Although expected to oxidize to some extent, when of a limited thickness and adequately set back from an underlying semiconductor source/drain material, an oxygen scavenging material incorporated into a contact metallization structure in accordance with embodiments herein may not significantly alter (e.g., increase) a metal-semiconductor barrier height associated with a particular source/drain contact metallization liner and source/drain semiconductor material. A contact metallization structure that may otherwise be susceptible to degradation through uncontrolled oxidation mechanisms may display improved and/or stabilized electrical performance with the addition of an oxygen scavenging material.

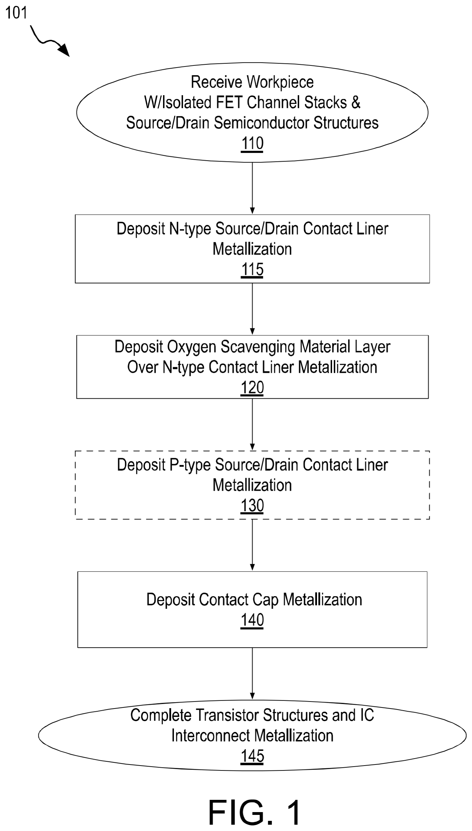

FIG. 1 is a flow diagram illustrating methods 101 for fabricating a transistor structure with an embedded oxygen scavenging or gettering material layer, in accordance with some exemplary embodiments. Methods 101 begin at input 110 with receipt of a workpiece including field effect transistor (FET) structures comprising source and drain semiconductor material coupled to channel semiconductor material layers within a channel stack. In some examples, the workpiece received at input 110 comprises a 300-450 mm diameter wafer. The workpiece may include a substantially monocrystalline subfin material and any number of transistor channel material layers over the subfin material. In exemplary embodiments, a transistor isolation structure comprising one or more dielectric materials is between adjacent transistor structures. Depending on the IC manufacturing process, various other transistor features may also be present on the workpiece. For example, transistor gate structures may also be present on the workpiece received at input 110.

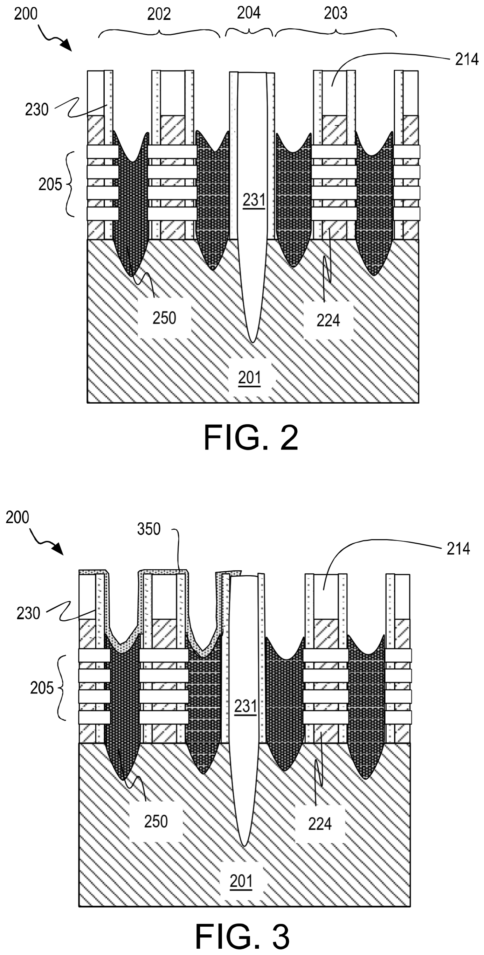

In the example illustrated in FIG. 2, a workpiece comprises IC structures 200, which further comprise a first transistor structure 202 over a subfin semiconductor material 201, a second transistor structure 203 over subfin semiconductor material 201. An intervening transistor isolation structure 204 is between transistor structures 202, 203. In the illustrated example, transistor structure 202 includes a first stack of transistor channel material layers 205. Transistor structure 203 similarly includes a second stack of transistor channel material layers 205. Transistor structure 202 may be associated with a first conductivity type while transistor structure 203 may be associated with a second conductivity type. In exemplary embodiments, transistor structure 202 is an N-type (NMOS) transistor structure while transistor structure 203 is a P-type (PMOS) transistor structure.

Isolation structure 204 may include one or more layers of one or more dielectric materials. In the illustrated example, isolation structure 204 includes sidewall spacer dielectric material 230 and a trench dielectric material 231. Trench dielectric material 231 may have any suitable composition, such as, but not limited to, one or more of SiO₂, Si₃N₄, SiON, etc. As shown, one body of source/drain semiconductor material 250 for each of transistor structures 202, 203 is in contact with isolation structure 204, and more specifically sidewall spacer dielectric material 230.

Channel material layers 205 may have any composition suitable for a channel of a field effect transistor (FET). In some examples, channel material layers 205 are substantially pure silicon. In other embodiments, channel material layers 205 comprise germanium (e.g., SiₓGe_{1-X}, GeₓSn_{1-X}, or substantially pure Ge). In some embodiments, channel material layers 205 include a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, and tellurium. In still other embodiments, channel material layer 205 comprise one or more metals and oxygen (i.e., metal oxide semiconductor), such as, but not limited to, Indium, gallium zinc oxide (IGZO).

Regardless of chemical composition, channel material layers 205 are advantageously crystalline. Although the crystalline semiconductor includes polycrystalline thin film material, in some embodiments channel material layers 205 are substantially monocrystalline. In some examples where channel material layers 205 are substantially pure silicon, the crystallinity of channel material layers 205 is cubic with a top surface having a crystallographic orientation of (100), (111), or (110). However, other crystallographic orientations are also possible. In other examples, channel material layers 205 may be polycrystalline or amorphous, for example in certain metal chalcogen and/or metal oxide embodiments.

As illustrated in FIG. 2, channel material layers 205 are over a subfin material 201. In exemplary embodiments, subfin material 201 is a portion a (mono)crystalline substrate material. For example, subfin material 201 may be substantially monocrystalline silicon (e.g., with only trace impurities and/or crystal defects). Transistor structures 202, 203 include a sidewall spacer dielectric material 230 protecting underlying channel material. Sidewall spacer dielectric material 230 may comprise a silicon-based dielectric (e.g., SiO₂, Si₃N₄, SiON, etc.). Optionally, adjacent channel material layers 205 may be recess etched, for example with an isotropic etch process selective to the channel semiconductor material, to form a dimple (not depicted) that may then be backfilled with an additional sidewall spacer dielectric material.

Transistor structures 202, 203 each further comprise a gate structure 224. In exemplary embodiments, gate structure 224 includes a gate material separated from channel material layers 205 by a gate insulator material. Gate structure 224 is between individual ones of channel material layers 205. The gate insulator material may have a relatively high dielectric constant(ε). In some high-K gate dielectric embodiments, the gate insulator material is a metal oxide comprising oxygen and one or more metals, such as, but not limited to, aluminum, hafnium, zirconium, tantalum, or titanium. In other embodiments, gate insulator material is a ferroelectric. In still other embodiments, gate insulator material may be primarily silicon oxide. The gate material may be, or include, a metal such as but not limited to platinum, nickel, molybdenum, tungsten, palladium, gold, alloys thereof, or nitrides such as titanium nitride, tantalum nitride, tungsten silicon nitride, etc.. In some embodiments, gate the material includes a work function metal and a fill metal (not depicted).

As further illustrated in FIG. 2, gate structure 224 includes a gate cap material 214, which may be any dielectric material of suitable composition. In some examples, gate cap material 214 is silicon oxide (SiO), silicon nitride (SiN), or silicon oxynitride, (SiON). Although only one layer is illustrated in FIG. 2, gate cap material 214 may comprise one or more material layers having a total thickness, for example in the range of 10-30nm.

Transistor structures 202, 203 further include source/drain semiconductor material 250, which may be impurity doped with donor species or acceptor species depending on whether the transistor structure is a NMOS or PMOS device, respectively. In some embodiments, source/drain semiconductor material 250 comprises silicon and may be predominantly silicon or further include other Group IV constituents in addition to the impurity dopants. In some exemplary embodiments where channel material layers 205 are associated with an NMOS FET structure, source/drain semiconductor material 250 is substantially pure silicon (i.e., only Group IV element is silicon) further including donor impurities imparting n-type electrical conductivity. The donor impurities may be any of phosphorus (P), arsenic (As), antimony (Sb), bismuth (Bi), selenium (Se), or tellurium (Te), for example. In other exemplary embodiments where channel material layers 205 are associated with a PMOS FET structure, source/drain semiconductor material 250 is substantially pure silicon or a Si₁₋ₓGeₓ alloy and further includes acceptor impurities imparting p-type electrical conductivity. The acceptor impurities may be any of boron (B), aluminum (Al), or gallium (Ga), for example.

Returning FIG. 1, methods 101continue at block 115 where one or more layers of an N-type contact metallization liner material are deposited. Contact metallization liner material may be deposited by PVD, CVD, or ALD, for example. The contact metallization liner material may be deposited selectively upon only N-type source/drain semiconductor material, or non-selectively deposited such that that the N-type contact metallization liner material is also formed over intervening transistor isolation structures.

FIG. 3 illustrates formation of a contact metallization liner material 350 over only transistor structure 202, for example due to the presence of a mask during a selective liner deposition or as a result of a post-deposition patterned etch of contact metallization liner material 350. In some alternative implementations, however, contact metallization liner material 350 may be retained over transistor structures of all conductivity types (i.e., also over transistor structure 203), for example where another (e.g., P-type) contact metallization liner material has already been deposited over corresponding source/drain semiconductor material bodies.

In exemplary embodiments, contact metallization liner material 350 is predominantly of one or more metals and is in direct contact with source/drain semiconductor material 250. Contact metallization liner material 350 is therefore an interfacial layer that will provide a low-resistance ohmic or tunneling semiconductor-metal junction with underlying N-type source/drain semiconductor material. Although not illustrated, contact metallization liner material 350 may also include a nucleation surface layer over the interfacial layer. The nucleation surface layer may have a different composition that the interfacial layer to promote the subsequent deposition of one or more additional layers of contact metallization that complete a low-resistance composite contact metallization structure or body.

Contact metallization liner material 350 may have a layer thickness less than 5nm, and in some advantageous embodiments is within a range of 0.5-2.0nm. In some examples, contact metallization liner material 350 comprises one or more of tungsten (W) or titanium (Ti). copper (Cu), tantalum (Ta), cobalt (Co), nickel (Ni), platinum (Pt), palladium (Pd), or aluminum (Al). Although the contact metallization liner material 350 may be a pure metal or metal alloy, the liner material may also comprise one or more of nitrogen (N) or carbon (C). Contact metallization liner material 350 may therefore include a single metals an alloy including two or more of metals, or a compound further including nitrogen (e.g., TiN or WN) or carbon (e.g., TiAlC, TiCₓN_{y}) to form a low-resistance contact to an n-type source and drain material. For some embodiments where source/drain semiconductor material 250 comprises silicon, contact metallization liner material 350 may react with the source/drain silicon, forming a metal-silicide (e.g., TiSiₓ).

In further embodiments, contact metallization liner material 350 comprises an impurity dopant suitable as an electrically active donor dopant within source/drain semiconductor material 250. Contact metallization liner material 350 may therefore comprise any of the donor impurities listed above, for example, at a concentration of 1-20 atomic (at.) %. In some advantageous embodiments where N-type source/drain semiconductor material 250 comprises P, contact metallization liner material 350 comprises 1-20 at. % P doping one or more of the metals above (e.g., P-doped Ti).

For embodiments where contact metallization liner material is deposited non-selectively, the contact metallization liner material may be subtractively patterned in preparation for a subsequent deposition of one or more additional metallization layers including at least one oxygen scavenging material. Although the contact metallization liner material may be patterned with any technique, in some embodiments a mask material is deposited over the contact metallization liner material, for example with a process where a top surface of the mask material is planarized with gate caps 214 and isolation structure 204 after backfilling recesses over source/drain semiconductor material 250 with the mask material.

Returning to FIG. 1, methods 101 continue at block 120 where an oxygen scavenging material layer is deposited over the contact liner metallization that was deposited at block 115. The oxygen scavenging material may be deposited by PVD, CVD, or ALD, for example. The oxygen scavenging material may be deposited selectively only over contact metallization liner material, or may be deposited non-selectively such that that the oxygen scavenging material is formed over substantially all of the N-type transistor structures (e.g., gate structures, source/drain semiconductor structures, etc.) and transistor isolation structures.

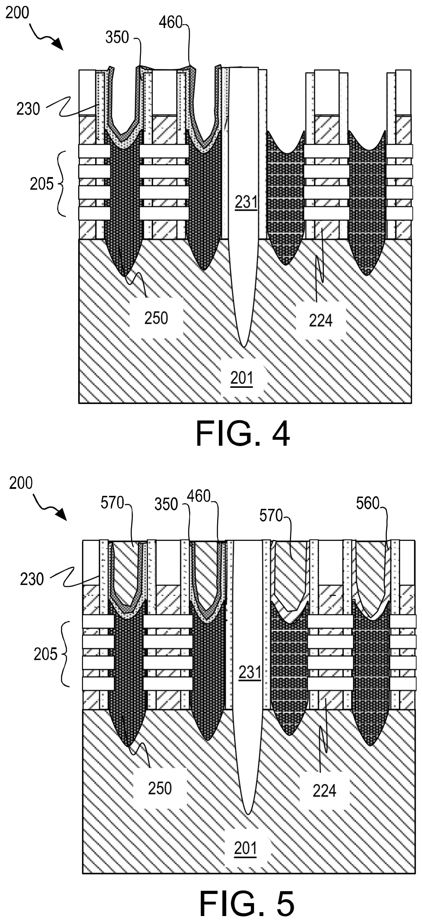

FIG. 4 illustrates formation of an oxygen scavenging material layer 460 over only transistor structure 202, for example due to the presence of a mask during a selective deposition or as the result of a post-deposition patterned etch of oxygen scavenging material layer 460. However, in some alternative implementations oxygen scavenging material layer 460 may be retained over transistor structures of all conductivity types (i.e., also over transistor structure 203), for example where a (e.g., P-type) contact metallization liner material has already been deposited over corresponding source/drain semiconductor material bodies.

In the illustrated embodiment, oxygen scavenging material 460 is in direct contact with contact metallization liner material 350. In other embodiments, one or more intervening layers of metallization (e.g., a nucleation layer) may be between oxygen scavenging material 460 and contact metallization liner material 350. In exemplary embodiments, oxygen scavenging material 460 comprises one or more metals that will readily oxidize and thereby remove oxygen from a contact metallization structure that may otherwise oxidize a portion of contact metallization liner material 350. While the inventors have found oxidation of contact metallization liner material 350 to degrade the low-resistance ohmic or tunneling semiconductor-metal junction formed with underlying N-type source/drain semiconductor material, sacrificial oxidation of scavenging material may not be as detrimental, particularly when of limited thickness and embedded within the contact metallization a distance away from the semiconductor material interface. Although not illustrated, oxygen scavenging material 460 may also include a nucleation surface layer of, for example to protect the scavenging layer from rapid oxidation and/or promote a subsequent deposition of one or more additional layers of contact metallization that complete a composite contact metallization structure. A nucleation surface layer may, for example, lack the elemental oxygen scavengers and/or comprise a different metal that will be subsequently deposited as contact metallization cap.

Oxygen scavenging material layer 460 may have a layer thickness less than 5nm, and in some advantageous embodiments within a range of 0.5-1.5nm. The thickness may be minimized to reduce the material's contribution to electrical resistance as it is expected to sacrificially oxidize to some extent. In some examples, oxygen scavenging material layer 460 comprises a rare earth metal, such as one or more of gadolinium (Gd) erbium (Er), samarium (Sm), neodymium (Nd), yttrium (Y), ytterbium (Yb), Lanthanum (La), Europium (Eu), Lutetium (Lu), Praseodymium (Pr), Terbium (Tb), Dysprosium (Dy), Holmium (Ho).

Although the oxygen scavenging material may be a pure rare earth metal or purely a rare earth metal alloy, the oxygen scavenging material may also comprise another metal, such as any of the metals listed above as suitable for contact metallization liner material 350, or any of the metals listed below as suitable for a contact metallization cap material. For some embodiments where source/drain semiconductor material 250 comprises silicon and contact metallization liner material 350 comprises Ti, oxygen scavenging material 460 comprises Ti and one of the above rare earth metals, particularly those that oxidize more rapidly.

In further embodiments, oxygen scavenging material 460 may also comprise an impurity dopant suitable as an electrically active donor dopant within source/drain semiconductor material 250. For example, where contact metallization liner material 350 comprise one of the donor impurities listed above (e.g., at a concentration of 1-20 atomic (at.) %.), oxygen scavenging material 460 may also include the same donor impurity. The donor impurity concentration may be the same as that of the liner material, or a lower concentration. Hence, in some embodiments where N-type source/drain semiconductor material 250 comprises phosphorus and contact metallization liner material 350 comprises 1-20 at. % phosphorus, oxygen scavenging material 460 may also comprise phosphorus. However, oxygen scavenging material 460 need not necessarily include any impurity dopant that is present in contact metallization liner material 350.

For embodiments where the oxygen scavenging material is deposited non-selectively, the oxygen scavenging material may be subtractively patterned in preparation for a subsequent deposition of one or more additional metallization layers including a cap metallization. Although the oxygen scavenging material may be patterned with any technique, in some embodiments a mask material is deposited over the oxygen scavenging material, for example with a process that planarizes a top surface of the mask material with gate caps 214 and isolation structure 204 after backfilling recesses over source/drain semiconductor material 250 with the mask material.

Returning to FIG. 1, methods 101 may continue at block 130 with the deposition of P-type contact liner metallization. Block 130 is illustrated in dashed line to emphasize the practice of block 130 is dependent on the implementation of p-type transistors and embodiments herein are not limited with respect to either p-type contact metallization structures or the fabrication techniques employed to fabricate such structures. In some embodiments, one or more layers of a P-type contact metallization liner material is deposited at block 130, for example by PVD, CVD, or ALD. The p-type contact metallization liner material may be deposited selectively only upon P-type source/drain semiconductor material, or non-selectively such that that the P-type contact metallization liner material is also formed over intervening transistor isolation structures.

After patterning (or selective deposition) of a contact metallization liner material, methods 101 continue at block 140 where metallization cap material is deposited over the oxygen scavenging material. In some examples, block 140 comprises a selective CVD or ALD process. In other embodiments, block 140 comprises a non-selective CVD or ALD process.

In the example illustrated in FIG. 5, bodies of metallization cap material 570 have been formed over oxygen scavenging material 460 and also over a p-type contact metallization liner material 560. Hence, in some embodiments where oxygen scavenging material 460 is absent from p-type contact metallization, metallization cap material 570 is in direct contact with p-type contact metallization liner material 560, but is not in direct contact with (n-type) contact metallization liner material 350. Metallization cap material 570 is instead in direct contact with oxygen scavenging material 460. In exemplary embodiments, contact metallization cap material 570 is advantageously predominantly W or Mo, and more advantageously substantially pure W or Mo. Contact metallization cap material 570 may have a top surface that has either been polished back to be substantially coplanar with isolation dielectric 231 and or gate cap 214, or may display a heightened surface roughness that is typical of a selectively grown metal that has not been polished back.

Returning to FIG. 1, methods 101 complete at output 145 where transistor structures may be completed accordingly to any known techniques to arrive at any architecture known to be suitable for FETs. Gate, source and drain terminals of the transistor structures may then be interconnected into integrated circuitry according to any known techniques. For example, any number of levels of backend metallization levels may be fabricated over the transistor structures. The workpiece may then be singulated into individual die, chips, or chiplets according to any suitable techniques. During backend processing, oxygen scavenging material within the contact metallization structures describe herein may function as an oxygen sink, for example forming a rare earth oxide. In exemplary embodiments, the oxygen scavenging layer acquires more O content than does the contact metallization liner material and may also acquire more oxygen than does the cap metallization material. A greater oxygen content within the rare-earth comprising scavenging layer is indicative of the function of the material and the benefit it offers to a contact metallization stack. Accordingly, contact metallization liner material in accordance with embodiments herein has minimal oxygen content (e.g., with an undetectable amount, or substantially free, of elemental oxygen).

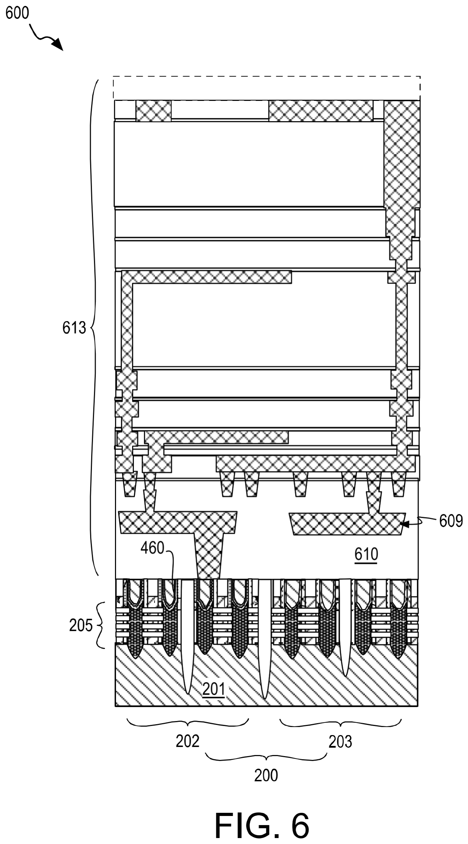

FIG. 6 illustrates an exemplary IC die structure 600 including a frontside transistor interconnect metallization structure 613, which further includes one or more interconnect metallization levels 609 embedded in dielectric material 610. Interconnect metallization levels 609 are interconnected to IC die structure 200, and more specifically to transistor structures 202, 203. In the illustrated example, a frontside metallization feature is in direct contact with a contact metallization cap material 570. Other frontside metallization features may similarly be electrically coupled to other bodies of contact metallization cap material 570 and/or gate structure 224. Although not illustrated, backside interconnect metallization levels may be similarly fabricated on an opposite side of transistor structures 202, 203. For example, subfin material 201 may be replaced with dielectric material and interconnect metallization levels.

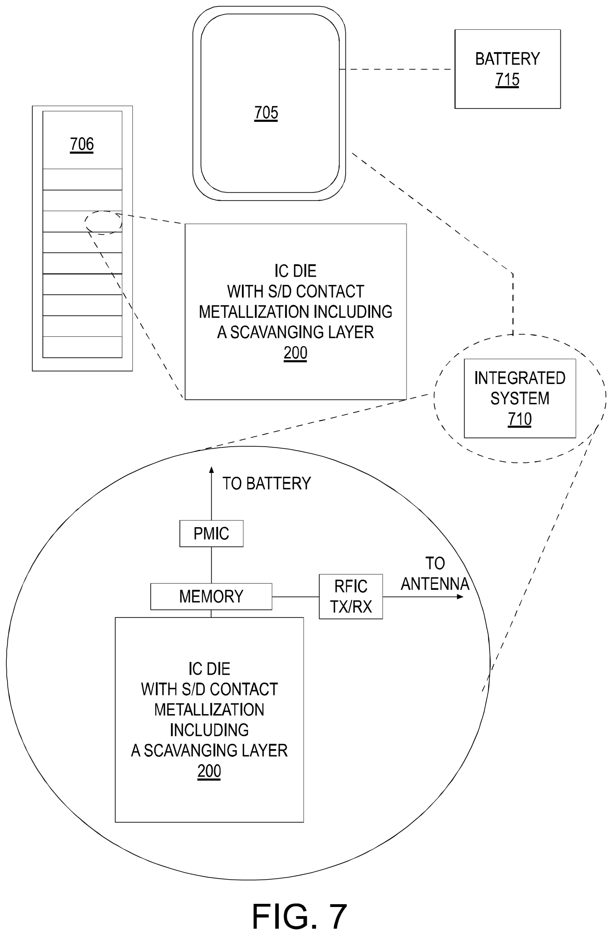

The transistor structures and IC die structures described above may be employed in a wide range of IC devices and further integrated in a wide range of computer-based applications. FIG. 7 illustrates a mobile computing platform 705 and a server machine 706, each employing IC die structure 200 including transistors with an embedded oxygen scavenging layer, for example as described elsewhere herein.

Server machine 706 may be any commercial server, for example including any number of high-performance computing platforms disposed within a rack and networked together for electronic data processing, which in the exemplary embodiment includes IC structure 200 comprising transistors with an embedded oxygen scavenging layer, for example as described elsewhere herein. The mobile computing platform 705 may be any portable device configured for each of electronic data display, electronic data processing, wireless electronic data transmission, or the like. For example, the mobile computing platform 705 may be any of a tablet, a smart phone, laptop computer, etc., and may include a display screen (e.g., a capacitive, inductive, resistive, or optical touchscreen), an integrated system 710, and a battery 715.

As illustrated in the expanded view of FIG. 7, one or more of a power management integrated circuit (PMIC) or RF (wireless) integrated circuit (RFIC) including a wideband RF (wireless) transmitter and/or receiver may be further coupled to IC die structure 200. A PMIC may perform battery power regulation, DC-to-DC conversion, etc., and so has an input coupled to battery 715 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

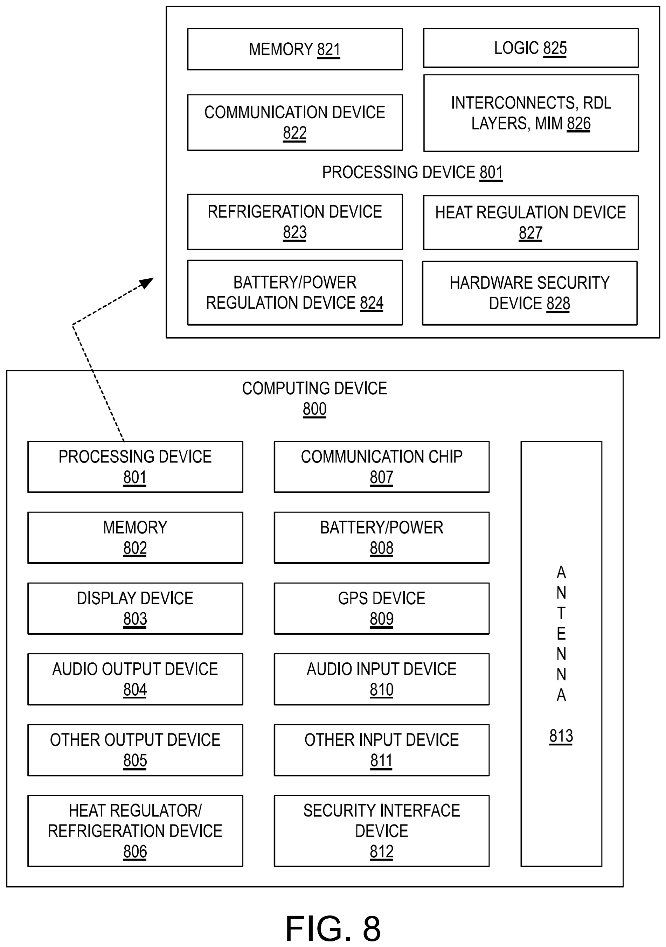

FIG. 8 is a block diagram of a cryogenically cooled computing device 800 in accordance with some embodiments. For example, one or more components of computing device 800 may include transistors with an embedded oxygen scavenging material, for example as described elsewhere herein. A number of components are illustrated in FIG. 8 as included in computing device 800, but any one or more of these components may be omitted or duplicated, as suitable for the application. In some embodiments, some or all of the components included in computing device 800 may be attached to one or more printed circuit boards (e.g., a motherboard). In some embodiments, various ones of these components may be fabricated onto a single system-on-a-chip (SoC) die. Additionally, in various embodiments, computing device 800 may not include one or more of the components illustrated in FIG. 8, but computing device 800 may include interface circuitry for coupling to the one or more components. For example, computing device 800 may not include a display device 803, but may include display device interface circuitry (e.g., a connector and driver circuitry) to which display device 803 may be coupled.

Computing device 800 may include a processing device 801 (e.g., one or more processing devices). As used herein, the term processing device or processor indicates a device that processes electronic data from registers and/or memory to transform that electronic data into other electronic data that may be stored in registers and/or memory. Processing device 801 may include a memory 821, a communication device 822, a refrigeration/active cooling device 823, a battery/power regulation device 824, logic 825, interconnects 826 (i.e., optionally including redistribution layers (RDL) or metal-insulator-metal (MIM) devices), a heat regulation device 827, and a hardware security device 828.

Processing device 801 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 801 may include a memory 802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 801 includes memory that shares a die with processing device 801. This memory may be used as cache memory and may include embedded dynamic random-access memory (eDRAM) or spin transfer torque magnetic random-access memory (STT-M RAM).

Computing device 800 may include a heat regulation/refrigeration device 806. Heat regulation/refrigeration device 806 may maintain processing device 801 (and/or other components of computing device 800) at a predetermined low temperature during operation. This predetermined low temperature may be any temperature discussed elsewhere herein.

In some embodiments, computing device 800 may include a communication chip 807 (e.g., one or more communication chips). For example, the communication chip 807 may be configured for managing wireless communications for the transfer of data to and from computing device 800. The term "wireless" and its derivatives may be used to describe circuits, devices, systems, methods, techniques, communications channels, etc., that may communicate data through the use of modulated electromagnetic radiation through a nonsolid medium.

Communication chip 807 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.).

In some embodiments, communication chip 807 may manage wired communications, such as electrical, optical, or any other suitable communication protocols (e.g., the Ethernet). As noted above, communication chip 807 may include multiple communication chips. For instance, a first communication chip 807 may be dedicated to shorter-range wireless communications such as Wi-Fi or Bluetooth, and a second communication chip 807 may be dedicated to longer-range wireless communications such as GPS, EDGE, GPRS, CDMA, WiMAX, LTE, EV-DO, or others. In some embodiments, a first communication chip 807 may be dedicated to wireless communications terminating at antenna 813, and a second communication chip 807 may be dedicated to wired communications.

Computing device 800 may include battery/power circuitry 808. Battery/power circuitry 808 may include one or more energy storage devices (e.g., batteries or capacitors) and/or circuitry for coupling components of computing device 800 to an energy source separate from computing device 800 (e.g., AC line power).

Computing device 800 may include a display device 803 (or corresponding interface circuitry, as discussed above). Display device 803 may include any visual indicators, such as a heads-up display, a computer monitor, a projector, a touchscreen display, a liquid crystal display (LCD), a light-emitting diode display, or a flat panel display, for example.

Computing device 800 may include an audio output device 804 (or corresponding interface circuitry, as discussed above). Audio output device 804 may include any device that generates an audible indicator, such as speakers, headsets, or earbuds, for example.

Computing device 800 may include an audio input device 810 (or corresponding interface circuitry, as discussed above). Audio input device 810 may include any device that generates a signal representative of a sound, such as microphones, microphone arrays, or digital instruments (e.g., instruments having a musical instrument digital interface (MIDI) output).

Computing device 800 may include a global positioning system (GPS) device 809 (or corresponding interface circuitry, as discussed above). GPS device 809 may be in communication with a satellite-based system and may receive a location of computing device 800, as known in the art.

Computing device 800 may include another output device 805 (or corresponding interface circuitry, as discussed above). Examples include an audio codec, a video codec, a printer, a wired or wireless transmitter for providing information to other devices, or an additional storage device.

Computing device 800 may include another input device 811 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 800 may include a security interface device 812. Security interface device 812 may include any device that provides security measures for computing device 800 such as intrusion detection, biometric validation, security encode or decode, managing access lists, malware detection, or spyware detection.

Computing device 800, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments described above, but can instead be practiced with modification and alteration without departing from the scope of the appended claims. For example, the above embodiments may include specific combinations of features as further provided below.

In first examples, an apparatus comprises a transistor structure. The transistor structure comprises one or more channel material features, a gate electrode structure wrapped around a center portion of the channel material features, and source and drain semiconductor materials coupled to end portions of the channel material features. The transistor structure comprises a contact metallization in contact with the source and drain semiconductor materials, wherein the contact metallization comprises a liner layer comprising predominantly a first metal a cap layer comprising predominantly a second metal and an intervening layer between the liner layer and the cap layer. The intervening layer comprises Gd, Er, Sm, Nd, Y, Yb, La, Eu, Lu, Pr, Tb, Dy, or Ho.

In second examples, for any of the first examples the intervening layer is an alloy further comprising Ti.

In third examples, for any of the second examples the second metal is W or Mo.

In fourth examples, for any of the third examples the source and drain semiconductor materials comprise silicon and one or more donor dopants, and the liner layer further comprises the one or more donor dopants at a concentration of at least 1 at. %.

In fifth examples, for any of the fourth examples the first metal is Ti and the one or more donor dopants comprises P.

In sixth examples, for any of the first through fifth examples the liner layer is no more than 5nm in thickness, and the intervening layer is no more than 5nm in thickness.

In seventh examples, for any of the sixth examples the liner layer is at least 0.5nm in thickness, and the intervening layer is at least 0.5nm in thickness.

In eighth examples, for any of the first through seventh examples the intervening layer comprises more O than the liner layer.

In ninth examples, for any of the eighth examples the intervening layer comprises more O than the cap layer.

In tenth examples, for any of the eighth through ninth examples the liner layer is substantially free of O.

In eleventh examples an integrated circuit (IC) structure comprises an isolation dielectric structure, and a n-type transistor structure on a first side of the isolation dielectric structure. The n-type transistor structure comprises a first gate around a plurality of transistor channel layers in a first stack, a first source or drain semiconductor material coupled to the channel layers in the first stack, a first body of contact liner metallization in contact with the first source or drain semiconductor material, and a first body of contact cap metallization separated from the first body of contact liner metallization by an intervening body of metallization comprising Gd, Er, Sm, Nd, Y, Yb, La, Eu, Lu, Pr, Tb, Dy, or Ho.

In twelfth examples, for any of the eleventh examples the IC device further comprises a p-type transistor structure on a second side of the isolation dielectric structure, opposite the n-type transistor structure. The p-type transistor structure, comprises a second gate around a plurality of transistor channel layers in a second stack, a second source or drain semiconductor material coupled to the channel layers in the second stack, a second body of contact liner metallization in contact with the second source or drain semiconductor material, and a second body of contact cap metallization in contact with the second body of contact liner metallization.

In thirteenth examples, for any of the twelfth examples the first source and drain semiconductor materials comprise silicon and one or more donor dopants, and the first body of liner metallization further comprises the one or more donor dopants at a concentration of at least 1 at. %.

In fourteenth examples, for any of the thirteenth examples the first body of liner metallization is predominantly Ti and the one or more donor dopants comprises P.

In fifteenth examples, for any of the eleventh through fourteenth examples the intervening body of metallization has a thickness of 0.5-1.5nm.

In sixteenth examples, for any of the fifteenth examples the intervening body of metallization is in direct contact with both the first body of liner metallization and the first body of cap metallization.

In seventeenth examples, for any of the eleventh through sixteenth examples the intervening body of metallization comprises more O than the first body of liner metallization.

In eighteenth examples, a method comprises receiving a workpiece comprising a channel material layer stack adjacent to a source or drain semiconductor material comprising silicon doped with a donor impurity, depositing a first metallization layer in contact with the source or drain semiconductor material, and depositing a second metallization layer in contact with the first metallization layer. The second metallization layer comprises Gd, Er, Sm, Nd, Y, Yb, La, Eu, Lu, Pr, Tb, Dy, or Ho. The method comprises depositing a third metallization layer over the second metallization layer.

In nineteenth examples, for any of the eighteenth examples depositing the first metallization layer further comprises depositing a first metal doped with the donor impurity.

In twentieth examples, for any of the eighteenth through nineteenth examples depositing the first metallization layer further comprises depositing Ti doped with P, and depositing the third metallization layer further comprises depositing W or Mo in direct contact with the second metallization layer.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An apparatus, comprising:
a transistor structure, wherein the transistor structure comprises:
one or more channel material features;
a gate electrode structure wrapped around a center portion of the channel material features; and
source and drain semiconductor materials coupled to end portions of the channel material features; and
a contact metallization in contact with the source and drain semiconductor materials, wherein the contact metallization comprises:
a liner layer comprising predominantly a first metal;
a cap layer comprising predominantly a second metal; and
an intervening layer between the liner layer and the cap layer, wherein the intervening layer comprises Gd, Er, Sm, Nd, Y, Yb, La, Eu, Lu, Pr, Tb, Dy, or Ho.

2. The apparatus of claim 1, wherein the intervening layer is an alloy further comprising Ti.

3. The apparatus of claim 2, wherein the second metal is W or Mo.

4. The apparatus of claim 3, wherein:
the source and drain semiconductor materials comprise silicon and one or more donor dopants; and
the liner layer further comprises the one or more donor dopants at a concentration of at least 1 at. %.

5. The apparatus of claim 4, wherein the first metal is Ti and the one or more donor dopants comprises P.

6. The apparatus of any one of claims 1-5, wherein:
the liner layer is no more than 5nm in thickness; and
the intervening layer is no more than 5nm in thickness.

7. The apparatus of claim 6, wherein:
the liner layer is at least 0.5nm in thickness; and
the intervening layer is at least 0.5nm in thickness.

8. The apparatus of any one of claims 1-5, wherein the intervening layer comprises more O than the liner layer.

9. The apparatus of claim 8, wherein the intervening layer comprises more O than the cap layer.

10. The apparatus of claim 8, wherein the liner layer is substantially free of O.

11. An integrated circuit (IC) structure, comprising:
an isolation dielectric structure; and
a n-type transistor structure on a first side of the isolation dielectric structure, wherein:
the n-type transistor structure, comprises:
a first gate around a plurality of transistor channel layers in a first stack;
a first source or drain semiconductor material coupled to the channel layers in the first stack;
a first body of contact liner metallization in contact with the first source or drain semiconductor material; and
a first body of contact cap metallization separated from the first body of contact liner metallization by an intervening body of metallization comprising Gd, Er, Sm, Nd, Y, Yb, La, Eu, Lu, Pr, Tb, Dy, or Ho.

12. The IC structure of claim 11, further comprising:
a p-type transistor structure on a second side of the isolation dielectric structure, opposite the n-type transistor structure, wherein:
the p-type transistor structure, comprises:
a second gate around a plurality of transistor channel layers in a second stack;
a second source or drain semiconductor material coupled to the channel layers in the second stack;
a second body of contact liner metallization in contact with the second source or drain semiconductor material; and
a second body of contact cap metallization in contact with the second body of contact liner metallization.

13. The IC structure of claim 12, wherein:
the first source and drain semiconductor materials comprise silicon and one or more donor dopants; and
the first body of liner metallization further comprises the one or more donor dopants at a concentration of at least 1 at. %.

14. The IC structure of claim 13, wherein the first body of liner metallization is predominantly Ti and the one or more donor dopants comprises P.

15. The IC structure of any one of claims 11-14, wherein:
the intervening body of metallization has a thickness of 0.5-1.5nm;
the intervening body of metallization is in direct contact with both the first body of liner metallization and the first body of cap metallization; and
the intervening body of metallization comprises more O than the first body of liner metallization.
